(19) Europäisches Patentamt

European Patent Office

Office européen des brevets

(11) **EP 0 673 564 B1**

(12) **EUROPEAN PATENT SPECIFICATION**

(45) Date of publication and mention
of the grant of the patent:
**29.03.2000 Bulletin 2000/13**

(51) Int. Cl.[7]: **H03M 7/24**, G06F 7/38

(21) Application number: **94902160.4**

(86) International application number:
**PCT/SE93/01039**

(22) Date of filing: **02.12.1993**

(87) International publication number:
**WO 94/14245 (23.06.1994 Gazette 1994/14)**

(54) **A DEVICE FOR CONVERSION OF A BINARY FLOATING-POINT NUMBER INTO A BINARY 2-LOGARITHM OR THE OPPOSITE**

VORRICHTUNG ZUR KONVERSION EINER BINÄREN GLEITKOMMAZAHL IN EINEN BINÄREN LOGARITHMUS MIT DER BASIS 2 ODER DESSEN UMKEHRUNG

DISPOSITIF DE CONVERSION D'UN NOMBRE BINAIRE A VIRGULE FLOTTANTE EN LOGARITHME-2 BINAIRE OU LE CONTRAIRE

(84) Designated Contracting States:
**DE DK FR GB**

(30) Priority: **07.12.1992 SE 9203683**

(43) Date of publication of application:
**27.09.1995 Bulletin 1995/39**

(73) Proprietor:
**Forskarpatent i Syd AB**
**223 70 Lund (SE)**

(72) Inventor: **HERTZ, Erik**
**S-582 47 Linköping (SE)**

(74) Representative:
**Hedefält, Dag et al**
**Försvarets Materielverk**
**Patentenheten**
**115 88 Stockholm (SE)**

(56) References cited:
**DE-A- 1 962 725**          **US-A- 4 855 741**

**Description**

The present invention concerns a device for conversion of a binary floating-point number into a binary fix-point 2-logarithm number or the opposite.

A present trend in radar system design is to move the digital signal processing as close to the antenna as possible. There are two reasons for this. Firstly the system will be less sensitive for interfering signals (disturbances) and secondly digital circuits are cheaper than corresponding analog circuits.

Digital signal processing for systems such as radar, radio and telephone require fairly high dynamic range, but can often tolerate a more limited relative accuracy. A method that reduces the number of bits used and in so doing is based on logarithmic conversion is therefore of interest. The main benefit of logarithmic conversion lies in the fact that multiplications and divisions are reduced to additions and subtractions, and powers and roots become simple shifts. The most common method to implement a logarithmic conversion is based on look-up tables. Read-Only Memories (ROM) can be used as tables, but most often they become large and introduce too large a delay for the systems in question.

The European patent application EP-A-0 572 695 to be considered under Art. 54(3) EPC shows an improved method using look-up tables.

Another way to convert an analog signal into a logarithmic one is known from Radar Handbook (2 ed.), M. Skolnik, 1990, McGraw-Hill, page 3.28-3.30. Here a piece-wise linear approximation is shown.

A binary floating-point number has the form

$$(\text{sign}) * \text{mantissa} * 2^{\text{exponent}},$$    where the mantissa and the exponent in the following calculations consist of a fixed number of bits.

The exponent is determined by the position of the Most Significant Bit (MSB) in the binary number. The mantissa is the MSB followed by the remaining bits as the fractional part. In the following only unsigned numbers will be considered, it is however not difficult to extend the method to signed numbers, which is immediately obvious to a man skilled in the art.

Example:

| Binary number | 0 1 0 1 1 1 0 1 1 0 |
|---|---|
| Position | 9 8 7 6 5 4 3 2 1 0 |

The MSB is in position 8 which gives the exponent $8_{dec} = 1000_{bin}$. The mantissa is $1.01110110_{bin}$.

A logarithm have the form an integer part, the characteristic, and a fractional part, the mantissa of the logarithm, whereby both the characteristic and the mantissa in the following calculations consist of a fixed number of bits.

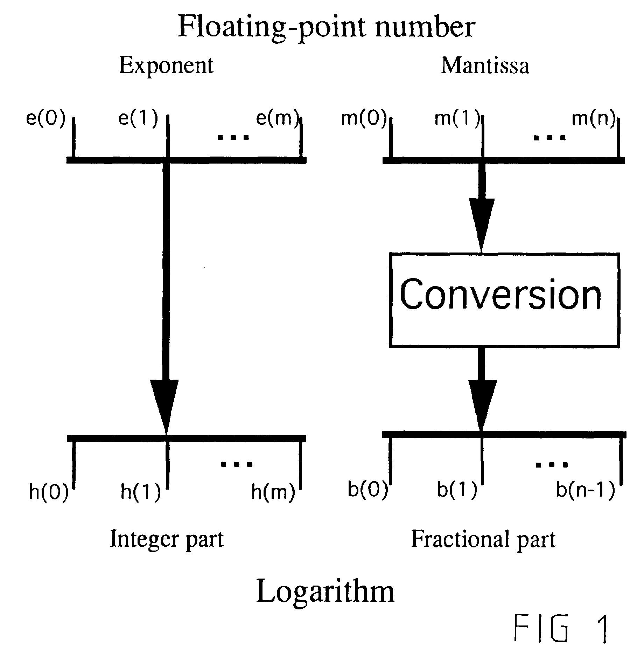

The known method of linear approximation is based on the resemblance between a binary floating-point number and a 2-logarithm in the binary fix-point format, cf. figure 1. Thus, the exponent of the floating point number and the integer part of the logarithm are equal. Further, the fractional part of the mantissa of the floating-point number can be used as an approximation of the mantissa of the logarithm.

Example:

| Decimal floating-point number | $9.6 * 10^1$ |
|---|---|
| Binary floating-point number | $1.\underline{100} * 2\underline{110}$ |
| Approximation of the logarithm | $\underline{110}.\underline{100}$ |

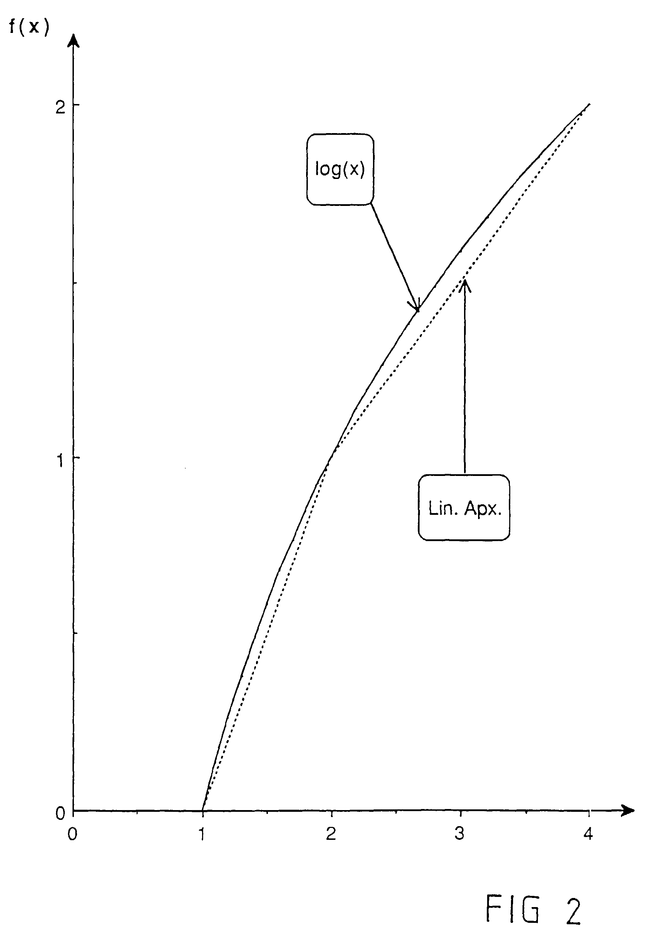

Figure 2 shows the graph of the $^2\log (x)$ and the linear approximation that is obtained if one uses the known method. It can be noted that the approximation gives the true value only in the points $x = 2^n$. Further it is evident that the approximation of the integer part of the logarithm always have the right value, where as the fractional part is always smaller or equal to the true value. Since the approximation always is smaller or equal to the true value, this known method of approximation is less suitable in relation with arithmetical operations.

The present invention is based on the latter method and means that it is corrected to reduce the error and, at a suitable choice of input system constants, distribute it on the whole evenly on both sides of the true value, which is what you wish. This is done by designing the invention according to the following independent claim. Further, the invention can, in an especially advantageous embodiment, be directly implemented on a digital VLSI-circuit.

In the following, the invention will be described in detail with reference to the attached drawings, where

fig 1     shows in principle how the conversion from a binary floating-point number into the 2-logarithm in binary form is performed,

fig 2     shows the graph of the function $f(x) = {}^2\log(x)$ and a known linear approximation of this function,

fig 3     shows a principle design according to the invention of how the conversion from the floating-point mantissa into the fractional part of the improved approximation of the logarithm can be done with additional parts in parallel,

fig 4     shows a principle design according to the invention of how the conversion from the floating-point mantissa into the fractional part of the improved approximation of the logarithm can be done with additional part in series,

fig 5     shows the principle design according to the invention of a part circuit that computes an additional part according to figure 3, 4, 11, and 12,

fig 6     show a concrete embodiment of the invention that performs a conversion from binary floating-point number into a 2-logarithm in binary form, at which <u>one</u> additional part and a constant = $0.25_{dec}$ are used,

fig 7     shows the graph of the function $f(x) = {}^2\log(x)$ and an approximation according to the invention of this, at which <u>one</u> additional part and a constant = $0.25_{dec}$ are used,

fig 8     shows a simplified flow chart of a computation according to the invention of

$$A = {}^2\log \sqrt{I^2 + Q^2},$$

fig 9     shows how the error was distributed at a computation according to figure 8,

fig 10    shows in principle how the conversion from the true 2-logarithm in binary form or the improved approximation of the same into a binary floating-point number is performed,

fig 11    shows a principle design according to the invention of how the conversion from the mantissa of the logarithm into the floating-point mantissa can be done with the additional parts in parallel,

fig 12    shows a principle design according to the invention of how the conversion from the mantissa of the logarithm into the floating-point mantissa can be done with the additional parts in series,

fig 13    show a concrete embodiment of the invention that performs a conversion from a 2-logarithm in binary form into a binary floating-point number, at which <u>one</u> additional part and a constant = $- 0.25_{dec}$ are used,

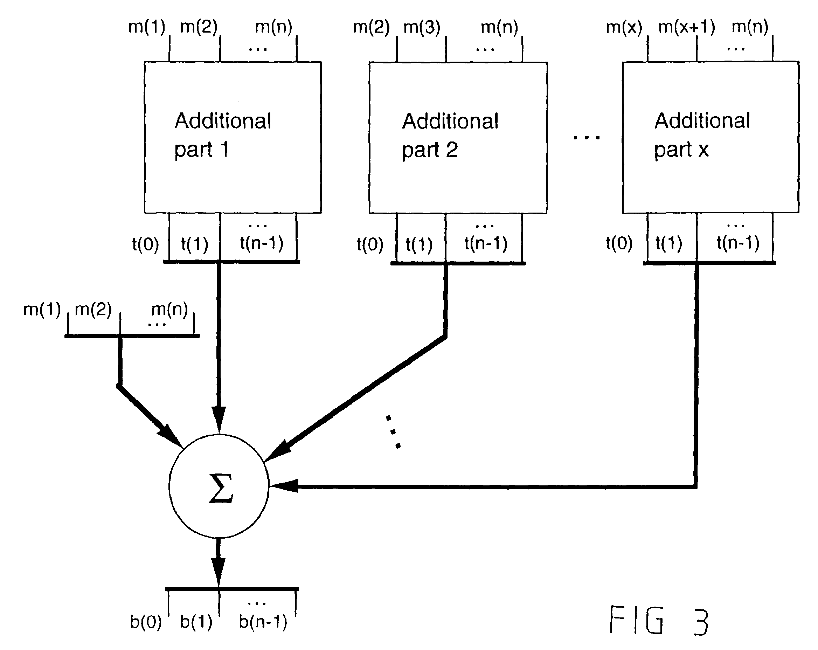

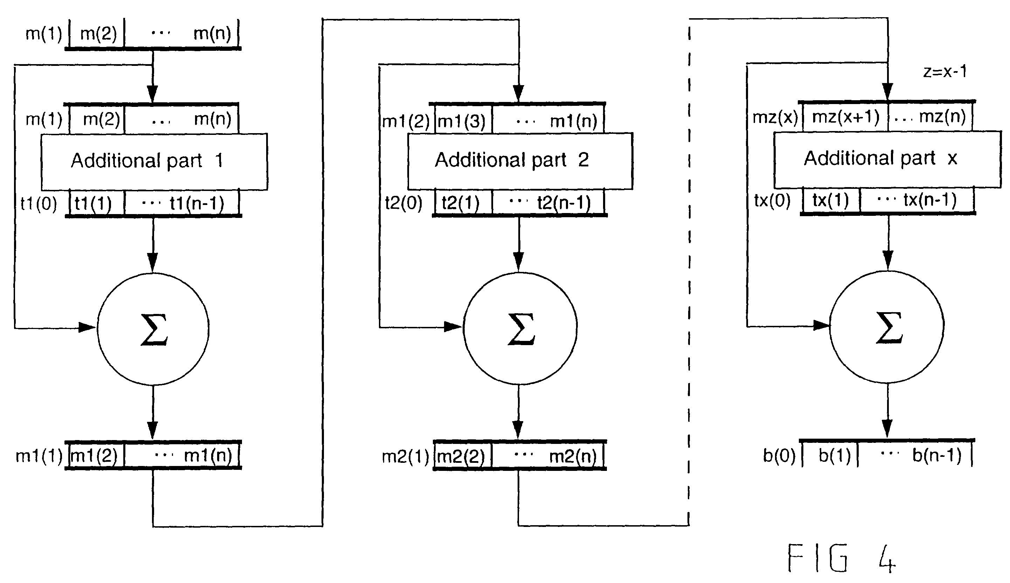

It can be noted directly from figure 2 that since the integer part in the known approximation always has the right value, it is the fractional part that needs to be improved. This can be done by an addition of one or more additional parts T in the form of further linear approximations, cf. figure 3 and 4.

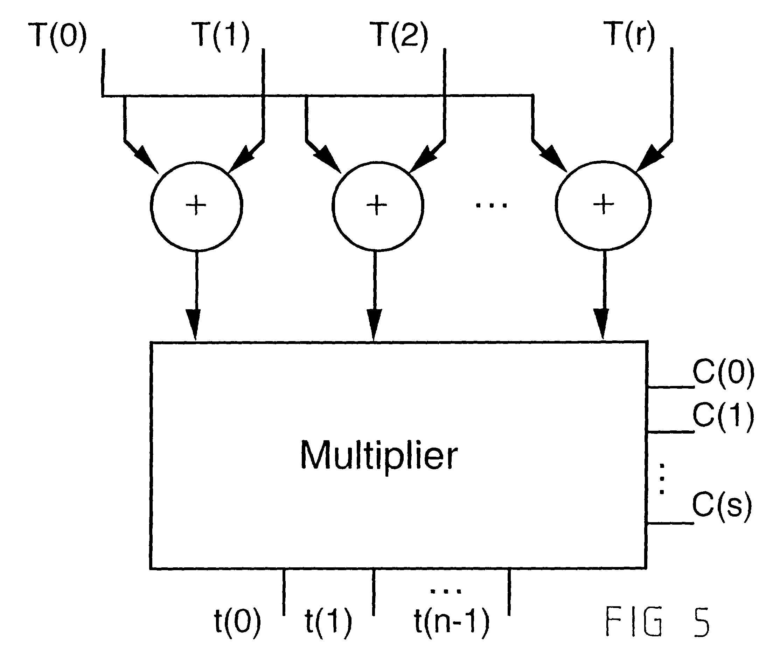

In figure 2 one can see, that if a function resembling a saw-tooth is added to the approximation, the error in relation to the true value can be reduced considerably. The present invention utilizes this idea. If one observes the known approximation of the logarithm in an interval where the fractional part goes from 0 to 1 (i.e. the integer part increases from n to n+1), one can observe that it is possible to create the wanted saw-tooth function by letting the most significant bit in the fractional part control a number of XOR-gates, cf. figure 5. The input signals to the XOR-gates are the remaining bits in the fractional part. This means that the remaining bits in the fractional part will be inverted, when the most significant bit in the fractional part of the known approximation of the logarithm is an one. The concrete implementation of the idea will be further introduced below.

At first the idea will be introduced in a more mathematical form in the following way. The saw-tooth function $S_n$ is generated from the fractional part $x_f$ of the well-known approximation according to

$$s_n = \begin{cases} x_f - \dfrac{2^n - \left(2^n - \dfrac{m}{2}\right)}{2^n} & , \text{m even} \\[4ex] -x_f + \dfrac{2^n - \left(2^n - \dfrac{m+1}{2}\right)}{2^n} & , \text{m odd} \end{cases}$$

where

$$\frac{m}{2^{n+1}} \le x_f < \frac{m+1}{2^{n+1}},$$

$m = 0,1,2, ..., 2^{n+1} - 1$

The saw-tooth function is then multiplied with coefficients $C_n$ in such a way that the sum of the additional part or parts and the original linear approximation is as close to the true value of the logarithm as one wishes. The accuracy of the approximation of the logarithm created in this way is determined by the number of additional parts in the form of saw-tooth functions that are used, as well as how well the coefficients are chosen.

The general equation for the approximation of the logarithm improved according to the invention $^2\log_{ap}(x)$ is shown below. The known approximation of the 2-logarithm is called $^2\log_{ex}(x)$ and its integer part $x_i$ and its fractional part $x_f$.

$$^2\log_{ex}(x) = x_i + x_f$$

$$^2\log_{ap}(x) = x_i + x_f + \sum_{n=0}^{k} C_n \cdot s_n$$

k is the number of terms used.

The opposite to the above, i.e. the conversion from the 2-logarithm in binary fix-point form into a binary floating-point number, in the form of an antilog function, is performed in a similar way. One subtracts one or more "additional parts" in the form of saw-tooth functions from the true logarithm or, as the case may be, the approximation of the logarithm improved according to the earlier computations, and obtains the known simple linear approximation of the logarithm according to figure 2. Then it is possible to go backwards from the integer part of the known approximation to the exponent of the binary floating-point number and from the fractional part of the known approximation to the fractional part of the mantissa of the floating-point number, which fractional part, after supplementing with an integer one, becomes the expression of the entire mantissa of the floating-point number.

The saw-tooth function $a_n$ is generated from the fractional part, the mantissa, $\log_f(x)$ of the correct logarithm or, the according to the invention computed, improved logarithm according to

$$a_n = \begin{cases} \log_f(x) - \dfrac{2^n - \left(2^n - \dfrac{m}{2}\right)}{2^n} & , \quad \text{m even} \\[4ex] -\log_f(x) + \dfrac{2^n - \left(2^n - \dfrac{m+1}{2}\right)}{2^n} & , \quad \text{m odd} \end{cases}$$

where

$$\frac{m}{2^{n+1}} \le \log_f(x) < \frac{m+1}{2^{n+1}} \, ,$$

$m = 0, 1, 2, ..., 2^{n+1} - 1$

The general equation for the according to the invention improved approximation of the fractional part $x_f$ of the antilogarithm $antilog_{ap}(x)$ is shown below.

$$x_f = \log_f(x) - \sum_{n=0}^{k} C_n \cdot s_n \, ,$$

k is the number of terms used

$$anti\log_{ap}(x) = (1.0 + x_f) \cdot 2^{x_i}$$

As is evident from the equations for $s_n$ and $a_n$ the same coefficients $C_n$ can be used.

A great advantage with the present invention is that it can easily be transferred into hardware in the form of an Application Specific Integrated Circuit, an ASIC. This digital circuit becomes smaller (and less complicated) as well as faster and more precise than earlier known circuits for the same application. The construction can be made with the help of registers, XOR-gates, multipliers and adders.

From the beginning, the exponent and mantissa of the floating-point number are placed in a register, cf. figure 1. The exponent is guided from this to a register designed to store the improved approximation of the logarithm after the conversion and is stored there directly as the integer part of this approximation. The fractional part of the mantissa of the floating-point number is guided, both directly to an adder, and also to one or more part circuits forming additional parts 1, 2, 3, ... . To the first part circuit all the bits of the fractional part are guided, to the second part circuit bit number two and the following bits of the fractional part are guided, to the third part circuit bit number three and the following bits of the fractional part are guided and so forth.

In figure 3 it is shown how several such additional parts are added in parallel while figure 4 shows an addition in series of the additional parts. Normally it is suitable to carry out the addition in parallel.

These part circuits, cf. figure 5, comprises a number of XOR-gates. To one of the inputs of these XOR-gates the most significant bit of the bits that are guided to each part circuit is guided and to the other input of each XOR-gate different following bits of the fractional part are guided, which means that the following bits are inverted when the most significant bit is 1 and are unchanged when this is 0.

The outputs from the XOR-gates will then be multiplied with a suitable scale factor, the constants $C_1$, $C_2$, ..., so the error is minimized. This can, as is shown in figure 5, be done by a multiplication in a multiplier.

In the adder or adders respectively the fractional part of the floating-point mantissa is added to the different additional parts, at which permanent zeros are put on the not connected inputs, also CIN (carry-in) is zero. The background for CIN to be put to zero, is that it is evident that the approximation is improved a little if the second flank of the saw-tooth function is somewhat lowered. A simple way to do this is to put CIN to zero instead of the normal one.

The result of the addition is guided to the register that stores the improved approximation of the logarithm after the conversion, where it forms the fractional part of this approximation.

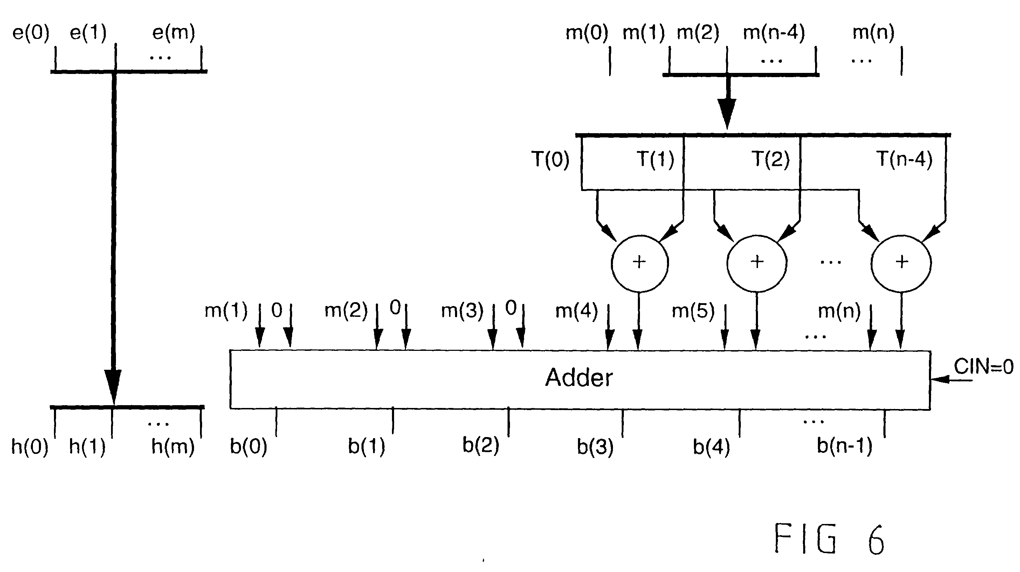

It has become apparent that for practical needs often only one additional part is needed and that the error becomes very small if the constant is chosen to $0{,}25_{dec}$. This is very fortunate since this corresponds to a shift two steps of the input of the additional part into the adder, as $0{,}25_{dec}$ is equal to $0{,}01_{bin}$, cf. figure 6. In this case no special multiplier is needed, the multiplication can be done in the routing of the circuit. In the same manner the multiplication could be carried out in the routing for other constants, in the cases when these are an even power of two. Accordingly, in all these cases the circuit gets simpler.

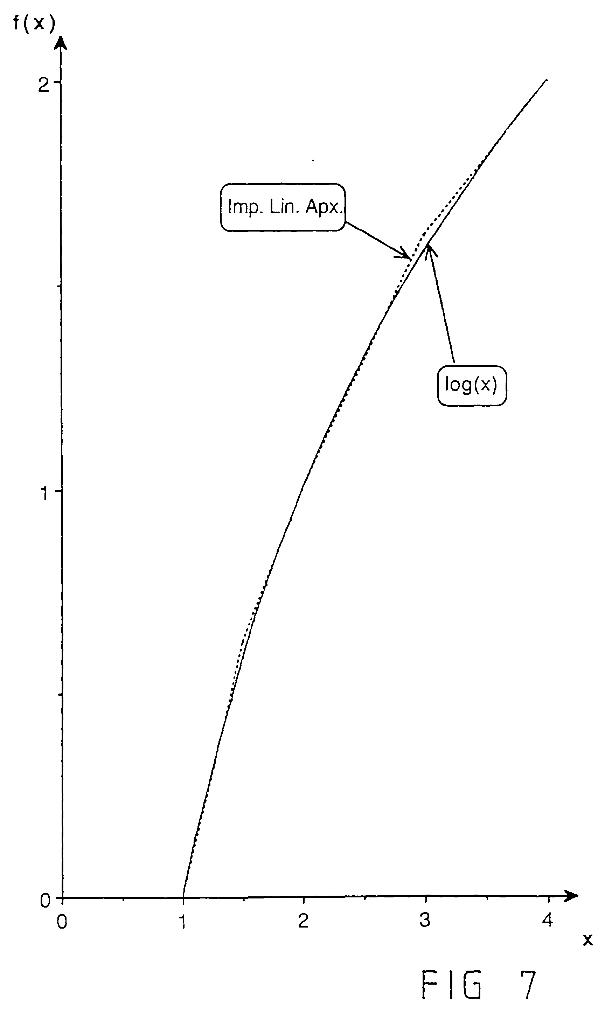

Figure 7 shows the graph of $^2\log(x)$ and the improved approximation of it that is obtained by the present invention, when using one additional part and the constant $= 0{,}25_{dec}$ according to the above. Through a direct comparison between figure 7 and figure 2 it is possible to see how much better the improved method of conversion is than the known.

The method of conversion according to the invention has also been tested by simulated calculations of a common radar algorithm that computes the amplitude A from the real part I and the imaginary part Q of the amplitude,

$$A = {}^2\log \sqrt{I^2 + Q^2}$$

The input signal and output signal of the processor were 11-bit and 8-bit respectively.

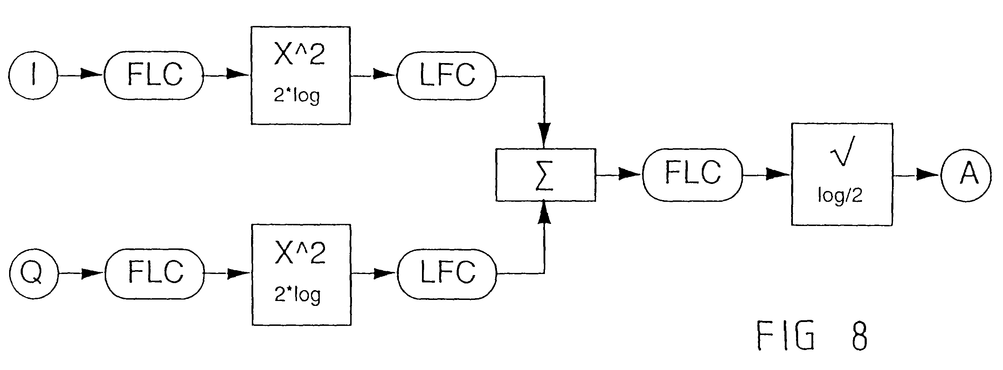

Figure 8 shows a simplified flow chart of the implementation of the computations. The incoming signals I and Q are already in floating-point form. The exponent uses 4 bits and the mantissa (without sign) 7 bits. In the first blocks FLC the floating point value is converted into logarithmic form in accordance with the method of the invention. Then the squaring is performed as a simple shift in logarithmic form. In the next blocks LFC the logarithms are converted back to floating-point form, as the next computation step is an addition. After the addition there is once again a conversion into logarithmic form in a FLC block, whereupon the square root is computed as a simple shift. Both the integer part and the fractional part of the logarithm output use 4 bits.

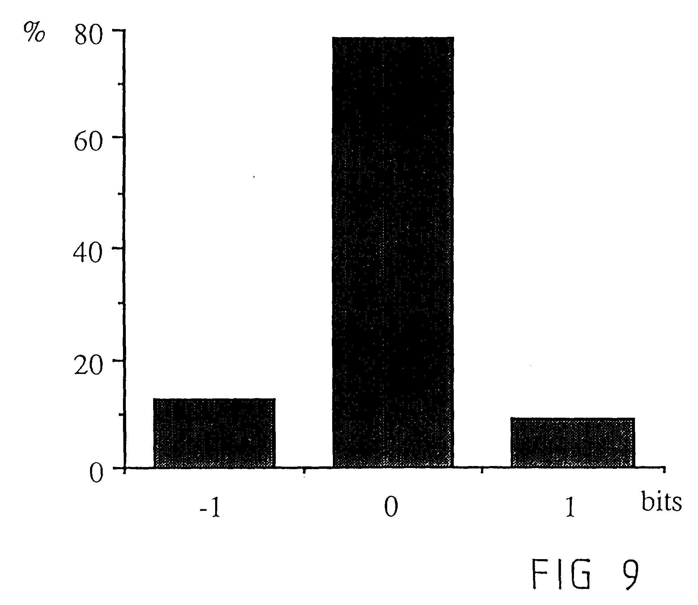

The simulation was carried out using 400.000 different complex numbers, all from the first quadrant of the complex plane. The result of the calculations performed according to the above was compared to the correctly calculated and rounded value of the amplitude. Figure 9 shows the distribution of the errors. It is evident that the calculation according to the invention never created a greater error than 1 bit in the mantissa of the logarithm and that in about 80% of the cases there is no error at all. Further it is evident that existing errors are relatively equally divided on both sides of the true value.

Then looking at the opposite, i.e. the conversion from the 2-logarithm in fix-point binary form into a binary floating-point number, the circuit in principle looks the same.

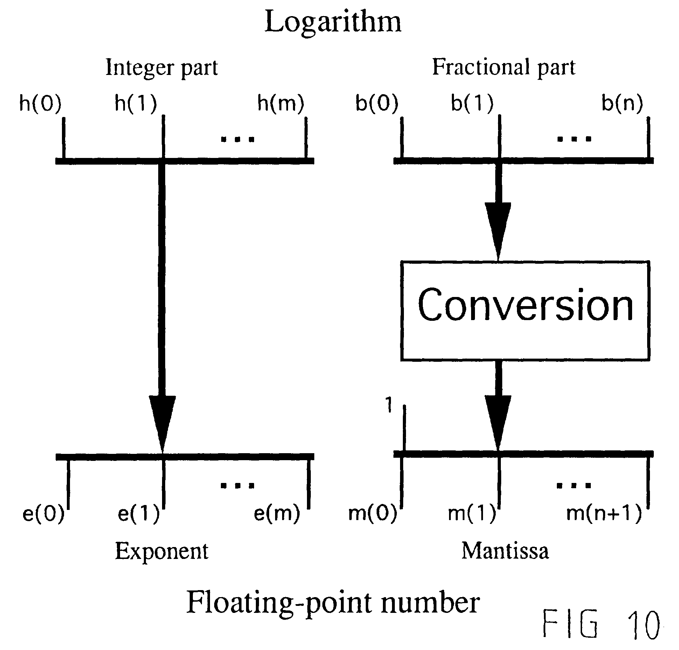

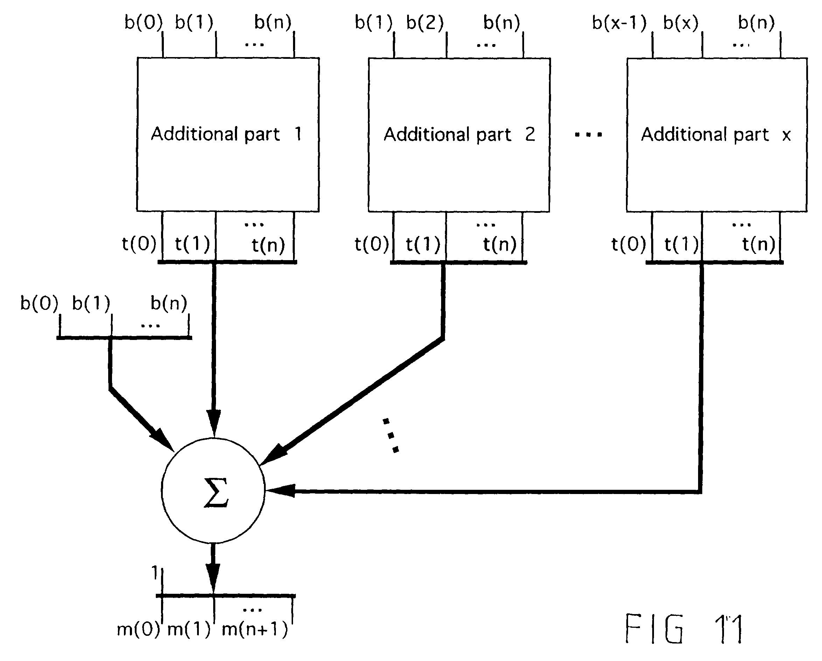

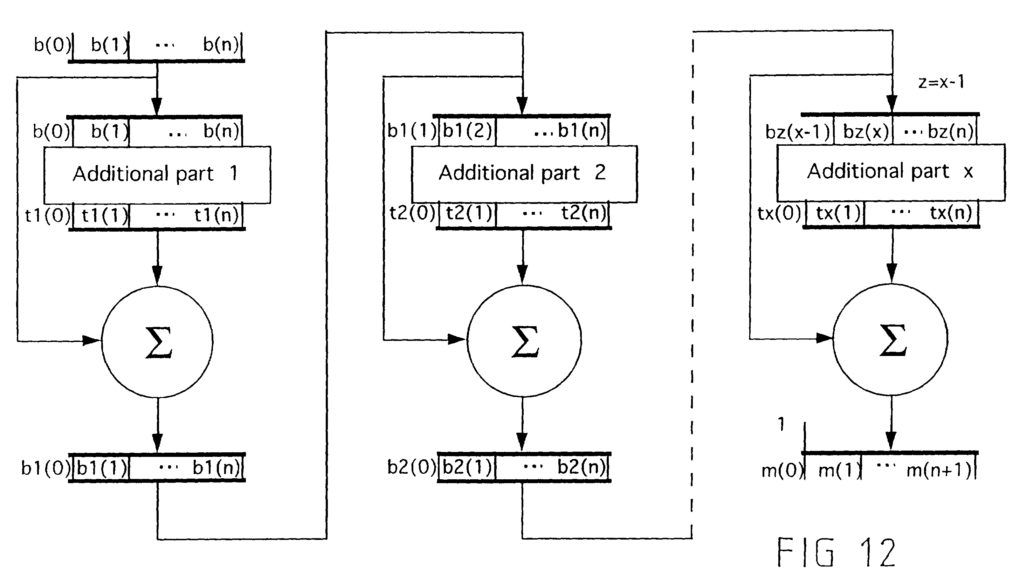

From the beginning, the characteristic and mantissa of the logarithm are placed in a register, cf. figure 10. The characteristic, the integer part, is guided from this to a register designed to store the floating-point number after the conversion and is stored there directly as its exponent. The mantissa of the logarithm is guided, cf. figure 11 and 12, both directly to an adder, and also to one or more part circuits forming additional parts 1, 2, 3, ... . To the first part circuit all the bits of the fractional part are guided, to the second part circuit bit number two and the following bits of the fractional part are guided, to the third part circuit bit number three and the following bits of the fractional part are guided and so forth.

In figure 11 it is shown how several such additional parts are added in parallel while figure 12 shows an addition in series of the additional parts. Normally it is suitable to carry out the addition in parallel.

These part circuits are identical to those that are used in the conversion from floating-point number into logarithm, cf. figure 5, and comprises a number of XOR-gates. To one of the inputs of these XOR-gates the most significant bit of the bits that are guided to each part circuit is guided and to the other input of each XOR-gate different following bits of the fractional part are guided, which means that the following bits are inverted when the most significant bit is 1 and are unchanged when this is 0.

The outputs from the XOR-gates will then be multiplied with a suitable scale factor, the constants $C_1$, $C_2$, ..., so the error is minimized. Note that the constants in this case are negative. This can, as is shown in figure 5, be done by a multiplication in a multiplier.

In the adder or adders respectively an initial one, which is to be the integer one (the MSB of the binary number) of the resulting binary floating-point number, is added to the fractional part of the real logarithm or the improved approximation of it and the different additional parts (that have negative sign), at which permanent ones are put on the not connected inputs, also CIN (carry-in) is one. The background for CIN to be put to one, is that it is evident that the approximation is improved a little if the second flank of the sawtooth function is somewhat raised. A simple way to do this is to put CIN to one instead of the normal zero.

The result of the addition is guided to the register that stores the floating-point number after the conversion, where it forms the mantissa of the floating-point number.

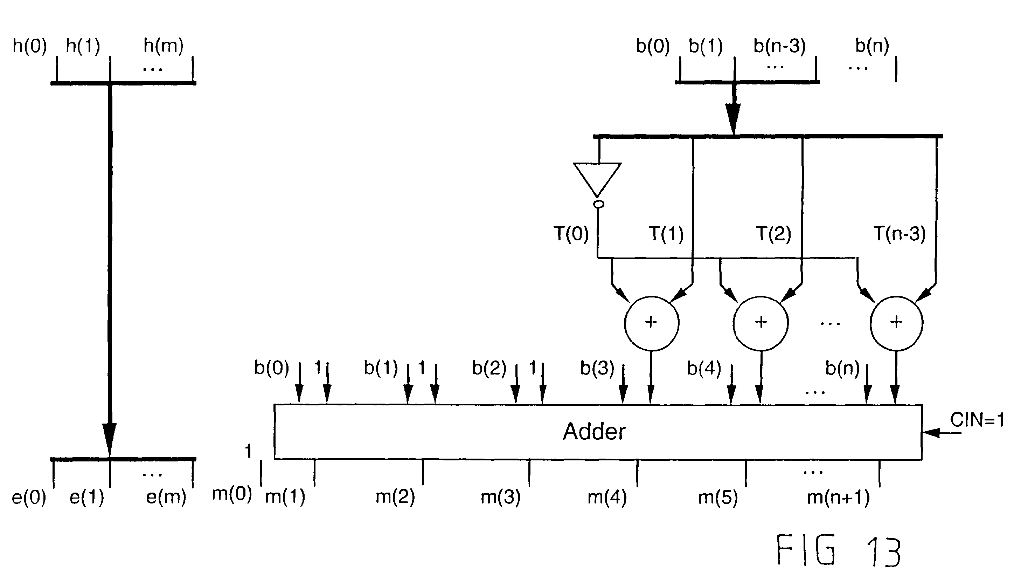

It has become apparent that for practical needs often only one additional part is needed and that the error becomes very small if the constant is chosen to $-0,25_{dec}$. This is very fortunate since this corresponds to a shift two steps of the input of the additional part into the adder, as $0,25_{dec}$ is equal to $0,01_{bin}$, cf. figure 13. In this case no special multiplier is needed, the multiplication can be done in the routing of the circuit. In the same manner the multiplication could be carried out in the routing for other constants, in the cases when these are an even power of two. Accordingly, in all these cases the circuit gets simpler.

The negative sign of the constant is here obtained by using an inverter. In figure 13 this is shown by the inverter that is located in the connection for the most significant bit, the bit that is guided to every XOR-gate within a part circuit, when computing the different additional parts.

**Claims**

1. A device for conversion by linear approximation of a binary floating-point number into a binary 2-logarithm, <u>characterized</u> in that it includes

> an input register where the floating-point number is stored,
> an output register for the calculated logarithm,

a device that transfers the exponent of the floating-point number from the input register to the output register, where it directly forms the characteristic of the logarithm,

a device that transfers the fractional part of the mantissa of the floating-point number from the input register to an adder and also to one or more part circuits each computing an additional part based upon the fractional part of the mantissa,

a device that transfers the additional parts to the adder,

said adder that adds the fractional part of the mantissa of the floating-point number and said additional parts and

a device that transfers the sum from the adder to the output register where it forms the fractional part of the 2-logarithm.

2. A device according to claim 1, <u>characterized</u> in that CIN on the adder is put to zero.

3. A device according to claim 1 or 2, <u>characterized</u> in that all bits in the fractional part of the mantissa of the floating-point number are directed to the first part circuit, bit number two and the following are directed to the possibly existing second part circuit, bit number three and the following are directed to the possibly existing third part circuit and so forth.

4. A device according to claim 3, <u>characterized</u> in that every part circuit comprises a number of XOR-gates, to the number of one less than the number of bits that are directed to the part circuit in question, at which the most significant bit of the bits that are directed to each part circuit is directed to the first input of all XOR-gates of this part circuit and the second bit is directed to the second input of the first XOR-gate of this part circuit, the third bit to the second input of the second XOR-gate of this part circuit, the fourth bit to the second input of the third XOR-gate of this part circuit and so forth.

5. A device for conversion by linear approximation of a binary 2-logarithm into a binary floating-point number, <u>characterized</u> in that it includes

an input register where the 2-logarithm is stared,

an output register for the calculated floating-point number,

a device that transfers the characteristic of the logarithm from the input register to the output register, where it directly forms the exponent of the floating-point number,

a device that transfers the mantissa of the logarithm from the input register to an adder and also to one or more part circuits each computing an additional part based upon the mantissa of the logarithm,

a device that transfers the additional parts to the adder,

said adder that adds the mantissa of the logarithm and said additional parts in order to create the fractional part of the mantissa of the floating-point number and adds this to an integer one and

a device that transfers the sum from the adder to the output register where it forms the mantissa of the floating-point number.

6. A device according to claim 5, <u>characterized</u> in that CIN on the adder is put to one.

7. A device according to claim 5 or 6, <u>characterized</u> in that all bits in the mantissa of the logarithm are directed to the first part circuit, bit number two and the following are directed to the possibly existing second part circuit, bit number three and the following are directed to the possibly existing third part circuit and so forth.

8. A device according to claim 7, <u>characterized</u> in that every part circuit comprises a number of XOR-gates, to the number of one less than the number of bits that are directed to the part circuit in question, at which the most significant bit of the bits that are directed to each part circuit is arranged to be directed to an inverter and then to the first input of all XOR-gates of this part circuit and the second bit is directed to the second input of the first XOR-gate of this part circuit, the third bit to the second input of the second XOR-gate of this part circuit, the fourth bit to the second input of the third XOR-gate of this part circuit and so forth.

9. A device according to claim 4 or 8, <u>characterized</u> in that the output signals from the XOR-gates are arranged to be multiplied with a suitable scale factor, the constants $C_1$, $C_2$ etc.

10. A device according to one of the previous claims, <u>characterized</u> in that the different additional parts are arranged to be added in parallel.

**11.** A device according to one of the previous claims, <u>characterized</u> in that the device is designed to use constants that are even powers of two and to carry out the multiplication with the help of the routing.

**12.** A device according to claim 11, <u>characterized</u> in that the device is arranged to use only one part circuit, which gives only one additional part, to use the constant $0,25_{dec} = 0.01_{bin}$, and to carry out the multiplication by adding in the adder the additional part shifted two steps to the mantissa of the floating-point number.

**13.** A device according to one of the claims 11 or 12, <u>characterized</u> in that it is carried out as an Application Specific Integrated Circuit.

**Patentansprüche**

**1.** Vorrichtung zur Konversion einer binären Gleitkommazahl in einen binären Logarithmus mit der Basis 2 durch lineare Approximation, dadurch gekennzeichnet, daß die Vorrichtung folgendes aufweist:

- ein Eingangsregister, in welchem die Gleitkommazahl gespeichert wird;
- ein Ausgangsregister für den berechneten Logarithmus;
- eine Vorrichtung, welche den Exponenten der Gleitkommazahl vom Eingangsregister zum Ausgangsregister, in welchem der Exponent direkt das charakteristische Merkmal des Logarithmus bildet, überträgt;
- eine Vorrichtung, welche die Stellen hinter dem Komma der Mantisse der Gleitkommazahl vom Eingangsregister zu einer Additionseinrichtung überträgt und zudem zu einem oder mehreren Teilgliedern, wobei jedes Teilglied basierend auf den Stellen hinter dem Komma der Mantisse einen zusätzlichen Bruchteil berechnet;
- eine Vorrichtung, die die zusätzlichen Bruchteile an die Additionseinrichtung überträgt;
- die Additionseinrichtung, welche die Stellen hinter dem Komma der Mantisse der Gleitkommazahl und die zusätzlichen Bruchteile addiert; und
- eine Vorrichtung, welche die Summe von der Additionseinrichtung zum Ausgangsregister, in welchem es die Stellen hinter dem Komma des Logarithmus mit der Basis 2 bildet, überträgt.

**2.** Vorrichtung nach Anspruch 1, dadurch gekennzeichnet, daß der Übertrag auf die Additionseinrichtung auf Null gestellt ist.

**3.** Vorrichtung nach Anspruch 1 oder 2, dadurch gekennzeichnet, daß alle Bits in den Stellen hinter dem Komma der Mantisse der Gleitkommazahl zum ersten Teilglied geleitet werden, das Bit mit der Zahl 2 und die folgenden zu dem möglicherweise bestehenden zweiten Teilglied geleitet werden, das Bit mit der Zahl 3 und die folgenden zu dem möglicherweise bestehenden dritten Teilglied geleitet werden, und so weiter.

**4.** Vorrichtung nach Anspruch 3, dadurch gekennzeichnet, daß jedes Teilglied eine Anzahl von exklusiven ODER-Schaltungen aufweist, wobei die Anzahl der exklusiven ODER-Schaltungen um 1 geringer als die Bitanzahl ist, welche zu dem betreffenden Teilglied geleitet wird, das signifikanteste Bit der Bits, welche an jedes Teilglied geleitet werden, an den ersten Eingang aller exklusiven ODER-Schaltungen dieses Teilglieds geleitet wird und das zweite Bit zum zweiten Eingang der ersten exklusiven ODER-Schaltung dieses Teilglieds geleitet wird, das dritte Bit zum zweiten Eingang der zweiten exklusiven ODER-Schaltung dieses Teilglieds, das vierte Bit zum zweiten Eingang der dritten exklusiven ODER-Schaltung dieses Teilglieds, und so weiter.

**5.** Vorrichtung zur Konversion eines binären Logarithmus mit der Basis 2 in eine binäre Gleitkommazahl durch lineare Approximation, dadurch gekennzeichnet, daß die Vorrichtung folgendes aufweist:

- ein Eingangsregister, in welchem der Logarithmus mit der Basis 2 gespeichert wird;
- ein Ausgangsregister für die berechnete Gleitkommazahl;
- eine Vorrichtung, welche das charakteristische Merkmal des Logarithmus vom Eingangsregister zum Ausgangsregister überträgt, wobei das charakteristische Merkmal im Ausgangsregister direkt den Exponenten der Gleitkommazahl bildet;
- eine Vorrichtung, welche die Mantisse des Logarithmus vom Eingangsregister zu einer Additionseinrichtung überträgt und zudem zu einem oder mehreren Teilgliedem, wobei jedes Teilglied basierend auf der Mantisse des Logarithmus einen zusätzlichen Bruchteil berechnet;
- eine Vorrichtung, die die zusätzlichen Bruchteile an die Additionseinrichtung überträgt;
- die Additionseinrichtung, welche die Mantisse des Logarithmus und die zusätzlichen Bruchteile zur Erzeugung der Stellen hinter dem Komma der Mantisse der Gleitkommazahl addiert und diese zu einer ganzen Zahl 1 addiert; und

- eine Vorrichtung, welche die Summe von der Additionseinrichtung zum Ausgangsregister, in welchem es die Mantisse der Gleitkommazahl bildet, überträgt.

**6.** Vorrichtung nach Anspruch 5, dadurch gekennzeichnet, daß der Übertrag auf die Additionseinrichtung 1 beträgt.

**7.** Vorrichtung nach Anspruch 5 oder 6, dadurch gekennzeichnet, daß alle Bits in der Mantisse des Logarithmus zum ersten Teilglied geleitet werden, das Bit mit der Zahl 2 und die folgenden zu dem möglicherweise bestehenden zweiten Teilglied geleitet werden, das Bit mit der Zahl 3 und die folgenden zu dem möglicherweise bestehenden dritten Teilglied geleitet werden, und so weiter.

**8.** Vorrichtung nach Anspruch 7, dadurch gekennzeichnet, daß jedes Teilglied eine Anzahl von exklusiven ODER-Schaltungen aufweist, wobei die Anzahl der exklusiven ODER-Schaltungen um 1 geringer als die Bitanzahl ist, welche zu dem betreffenden Teilglied geleitet wird, das signifikanteste Bit der Bits, welche zu jedem Teilglied geleitet werden, so angeordnet ist, daß es zu einem Inverter geleitet wird und anschließend zu dem ersten Eingang von allen exklusiven ODER-Schaltungen dieses Teilglieds und das zweite Bit zu dem zweiten Eingang der ersten exklusiven ODER-Schaltung dieses Teilglieds geleitet wird, das dritte Bit zu dem zweiten Eingang der zweiten exklusiven ODER-Schaltung dieses Teilglieds, das vierte Bit zu dem zweiten Eingang der dritten exklusiven ODER-Schaltung dieses Teilglieds, und so weiter.

**9.** Vorrichtung nach den Ansprüchen 4 oder 8, dadurch gekennzeichnet, daß die Ausgangssignale von den exklusiven ODER-Schaltungen mit einem geeigneten Skalierungsfaktor, den Konstanten $C_1$, $C_2$ usw. multipliziert werden.

**10.** Vorrichtung nach einem der vorhergehenden Ansprüche, dadurch gekennzeichnet, daß die unterschiedlichen zusätzlichen Bruchteile so angeordnet sind, daß sie paralleladdiert werden.

**11.** Vorrichtung nach einem der vorhergehenden Ansprüche, dadurch gekennzeichnet, daß die Vorrichtung so konstruiert ist, daß sie Konstanten verwendet, die gerade Potenzen von 2 sind, und weiter die Muliplikation mit Hilfe des Leitwegs durchführt.

**12.** Vorrichtung nach Anspruch 11, dadurch gekennzeichnet, daß die Vorrichtung so angeordnet ist, daß sie nur ein Teilglied verwendet, welches nur einen zusätzlichen Bruchteil ergibt, weiter die Konstante $0{,}25_{dec} = 0.01_{bin}$ verwendet, und die Muliplikation durch Addition des zusätzlichen Bruchteils, welcher zwei Stufen verschoben ist, zur Mantisse der Gleitkommazahl in der Additionseinrichtung durchführt.

**13.** Vorrichtung nach einem der Ansprüche 11 oder 12, dadurch gekennzeichnet, daß sie als ein anwendungsspezifischer integrierter Schaltkreis ausgeführt ist.

**Revendications**

**1.** Dispositif de conversion, par une approximation linéaire, d'un nombre binaire à virgule flottante en un logarithme-2 binaire, caractérisé en ce qu'il comprend:

- un registre d'entrée dans lequel est stocké le nombre à virgule flottante,
- un registre de sortie pour le logarithme calculé,
- un dispositif qui transfère l'exposant du nombre à virgule flottante du registre d'entrée vers le registre de sortie dans lequel il forme directement la caractéristique du logarithme,
- un dispositif qui transfère la partie fractionnaire de la mantisse du nombre à virgule flottante du registre d'entrée vers un additionneur, et également vers un ou plusieurs circuits partiels calculant chacun une partie supplémentaire sur la base de la partie fractionnaire de la mantisse,
- un dispositif qui transfère les parties supplémentaires vers l'additionneur,
- l'additionneur qui ajoute la partie fractionnaire de la mantisse du nombre à virgule flottante, avec les parties supplémentaires, et
- un dispositif qui transfère la somme de l'additionneur vers le registre de sortie dans lequel elle forme la partie fractionnaire du logarithme-2.

**2.** Dispositif selon la revendication 1, caractérisé en ce que le CIN (carry-in) de l'additionneur est placé à zéro.

3. Dispositif selon la revendication 1 ou 2, caractérisé en ce que tous les bits dans la partie fractionnaire de la mantisse du nombre à virgule flottante sont dirigés vers le premier circuit partiel, le bit de numéro deux et les bits suivants étant dirigés vers le second circuit partiel existant éventuellement, le bit de numéro trois et les bits suivants étant dirigés vers le troisième circuit partiel existant éventuellement, et ainsi de suite.

4. Dispositif selon la revendication 3, caractérisé en ce que chaque circuit partiel comprend un certain nombre de portes OU-exclusif, en nombre inférieur d'une unité au nombre de bits qui sont dirigés vers le circuit partiel en question, dans lesquelles le bit le plus significatif des bits dirigés vers chaque circuit partiel, est dirigé vers la première entrée de toutes les portes OU-exclusif de ce circuit partiel, tandis que le second bit est dirigé vers la seconde entrée de la première porte OU-exclusif de ce circuit partiel, le troisième bit est dirigé vers la seconde entrée de la seconde porte OU-exclusif de ce circuit partiel, le quatrième bit est dirigé vers la seconde entrée de la troisième porte OU-exclusif de ce circuit partiel, et ainsi de suite.

5. Dispositif de conversion, par une approximation linéaire, d'un logarithme-2 binaire en un nombre binaire à virgule flottante, caractérisé en ce qu'il comprend:

- un registre d'entrée dans lequel est stocké le logarithme-2,
- un registre de sortie pour le nombre à virgule flottante calculé,
- un dispositif qui transfère la caractéristique du logarithme du registre d'entrée vers le registre de sortie dans lequel il forme directement l'exposant du nombre à virgule flottante,
- un dispositif qui transfère la mantisse du logarithme du registre d'entrée vers un additionneur ainsi que vers un ou plusieurs circuits partiels calculant chacun une partie supplémentaire sur la base de la mantisse du logarithme,
- un dispositif qui transfère les parties supplémentaires vers l'additionneur,
- l'additionneur qui ajoute la mantisse du logarithme aux parties supplémentaires pour créer la partie fractionnaire de la mantisse du nombre à virgule flottante, et l'ajoute à un nombre entier un, et
- un dispositif qui transfère la somme de l'additionneur vers le registre de sortie dans lequel elle forme la mantisse du nombre à virgule flottante.

6. Dispositif selon la revendication 5, caractérisé en ce que le CIN sur l'additionneur est placé à un.

7. Dispositif selon la revendication 5 ou 6, caractérisé en ce que tous les bits dans la mantisse du logarithme sont dirigés vers le premier circuit partiel, le bit de numéro deux et les bits suivants étant dirigés vers le second circuit partiel éventuellement existant, le bit de numéro 3 et les bits suivants étant dirigés vers le troisième circuit partiel éventuellement existant, et ainsi de suite.

8. Dispositif selon la revendication 7, caractérisé en ce que chaque circuit partiel comprend un certain nombre de portes OU-exclusif, en nombre inférieur d'une unité au nombre de bits qui sont dirigés vers le circuit partiel en question, dans lesquelles le bit le plus significatif des bits dirigés vers chaque circuit partiel, est disposé pour être dirigé vers un inverseur puis vers la première entrée de toutes les portes OU-exclusif de ce circuit partiel, tandis que le second bit est dirigé vers la seconde entrée de la première porte OU-exclusif de ce circuit partiel, le troisième bit est dirigé vers la seconde entrée de la seconde porte OU-exclusif de ce circuit partiel, le quatrième bit est dirigé vers la seconde entrée de la troisième porte OU-exclusif de ce circuit partiel, et ainsi de suite.

9. Dispositif selon la revendication 4 ou 8, caractérisé en ce que les signaux de sortie provenant des portes OU-exclusif sont prévus pour être multipliés par un facteur d'échelle convenable, c'est à dire les constantes $C_1$, $C_2$, etc.

10. Dispositif selon l'une des revendications précédentes, caractérisé en ce que les parties supplémentaires différentes sont disposées pour être additionnées en parallèle.

11. Dispositif selon l'une des revendications précédentes, caractérisé en ce que le dispositif est conçu pour utiliser des constantes qui sont des puissances paires de deux, et pour effectuer la multiplication à l'aide de la pose des conducteurs.

12. Dispositif selon la revendication 11, caractérisé en ce que le dispositif est conçu pour n'utiliser qu'un seul circuit partiel qui ne donne qu'une seule partie supplémentaire, pour utiliser la constante $0,25_{dec}=0,01_{bin}$, et pour effectuer la multiplication en ajoutant, dans l'additionneur, la partie supplémentaire décalée de deux degrés vers la mantisse du nombre à virgule flottante.

13. Dispositif selon l'une des revendications 11 ou 12, caractérisé en ce qu'il est réalisé sous la forme d'un Circuit Intégré à Application Spécifique (ASIC).

# Floating-point number

Exponent    Mantissa

Integer part    Fractional part

# Logarithm

FIG 1

**FIG 2**

FIG 3

FIG 4

FIG 5

EP 0 673 564 B1

FIG 6

EP 0 673 564 B1

FIG 7

FIG 8

FIG 9

# Logarithm

Integer part

Fractional part

h(0)    h(1)         h(m)    b(0)    b(1)         b(n)

. . .                           . . .

Conversion

1

e(0)    e(1)         e(m)    m(0)    m(1)         m(n+1)

Exponent                        Mantissa

## Floating-point number

FIG 10

EP 0 673 564 B1

b(0) b(1) b(n)
...
b(1) b(2) b(n)
...
b(x-1) b(x) b(n)
...

| Additional part 1 | Additional part 2 | ... | Additional part x |

...
t(0) t(1) t(n)
...
t(0) t(1) t(n)
...
t(0) t(1) t(n)

b(0) b(1) b(n)
...

$\Sigma$

1
...
m(0) m(1) m(n+1)

FIG 11

EP 0 673 564 B1

FIG 12

EP 0 673 564 B1

FIG 13

EP 0 673 564 B1